# EUROPÄISCHE PATENTSCHRIFT

(11) **EP 3 631 203 B1**
(45) Veröffentlichungstag und Bekanntmachung des Hinweises auf die Patenterteilung: **09.03.2022**
(21) Anmeldenummer: 18740081.7
(22) Anmeldetag: 23.05.2018
(51) Int. Cl.: C23C 4/06, C23C 4/067, C23C 28/00, F03D 80/70, F16C 17/10, F16C 25/02, F16C 33/14, F03D 15/00, F16H 57/08, F16C 17/02

(54) **WINDKRAFTANLAGENGETRIEBE UND VERFAHREN ZUR HERSTELLUNG EINER ACHSE FÜR EIN WINDKRAFTANLAGENGETRIEBE**
WIND TURBINE GEARBOX AND METHOD OF MANUFACTURING AN AXLE FOR A WIND TURBINE GEARBOX
MULTIPLICATEUR D'ÉOLIENNE ET MÉTHODE DE FABRICATION D'UN AXE POUR UN MULTIPLICATEUR D'ÉOLIENNE

(30) Priorität: 23.05.2017 AT 5009717 U
(43) Veröffentlichungstag der Anmeldung: 08.04.2020
(73) Patentinhaber: Miba Gleitlager Austria GmbH, 4663 Laakirchen (AT)
(72) Erfinder: HAGER, Gunther, 4563 Micheldorf in Oberösterreich (AT); HÖLZL, Johannes Sebastian, 4880 Berg im Attergau (AT)
(74) Vertreter: Burger, Hannes
(86) Internationale Anmeldenummer: PCT/AT2018/060104
(87) Internationale Veröffentlichungsnummer: WO 2018/213861

(56) Entgegenhaltungen:
- EP-A1- 2 383 480
- WO-A1-2013/106879
- JP-B- S5 948 861

## Beschreibung

Die Erfindung betrifft ein Windkraftanlagengetriebe, insbesondere ein Planetengetriebe, mit zumindest einem Zahnrad, das auf einer Achse gelagert ist, wozu zwischen dem Zahnrad und der Achse eine Gleitschicht angeordnet ist.

Weiter betrifft die Erfindung eine Windkraftanlage mit einem Rotor und einem Generator, wobei zwischen dem Rotor und dem Generator ein Windkraftanlagengetriebe, insbesondere ein Planetengetriebe, angeordnet ist, das in Wirkverbindung mit dem Rotor und dem Generator steht.

Zudem betrifft die Erfindung ein Verfahren zur Herstellung einer Achse für ein Windkraftanlagengetriebe, insbesondere ein Planetengetriebe.

Planetengetriebe für Windkraftanlagen zur Erzeugung von elektrischem Strom, wie sie zum Beispiel aus der DE 102 60 132 A1 bekannt sind, werden dazu verwendet, um die relativ geringe Drehzahl des Rotors der Windkraftanlage in eine höhere Drehzahl des Generatorrotors zu übersetzten. Üblicherweise werden in derartigen Planetengetrieben, wie dies ebenfalls in der DE 102 60 132 A1 beschrieben ist, Wälzlager als Lagerelemente für die Planetenräder verwendet. Der Stand der Technik beschreibt aber auch Gleitlager als Lagerelemente, beispielsweise die EP 1 544 504 A2 oder die AT 509 624 A1. Als Gleitlager werden dabei üblicherweise Gleitlagerbüchsen verwendet, die auf die Achse aufgeschrumpft oder in das Planetenrad eingepresst sind. Der Austausch derartiger Gleitlager im Falle einer Wartung oder im Falle von Verschleiß ist aufwändig und damit kostenintensiv. EP 2 383 480 A1 offenbart ein Windkraftanlagegetriebe nach dem Oberbegriff des Anspruchs 1.

Die Aufgabe der Erfindung ist es, eine Gleitlagerlösung für ein Windkraftanlagengetriebe zur Verfügung zu stellen, die einfach zu Warten ist.

Die Aufgabe wird mit dem eingangs genannten Windkraftanlagengetriebe gelöst, bei dem die Gleitschicht mittels eines thermischen Spritzverfahrens direkt auf die Achse oder unter Zwischenanordnung von zumindest einer weiteren Schicht auf die Zwischenschicht aufgespritzt ist.

Weiter wird die Aufgabe mit der eingangs genannten Windkraftanlage gelöst, bei der das Windkraftanlagengetriebe erfindungsgemäß ausgebildet ist.

Zudem wird die Aufgabe der Erfindung mit dem eingangs genannten Verfahren gelöst, dass die Schritte Bereitstellen der Achse und Aufspritzen einer Gleitschicht aus einem Spritzwerk-stoff mit einem thermischen Spritzverfahren direkt auf die Achse oder nach dem Auftrag zumindest einer metallischen Zwischenschicht auf die Zwischenschicht umfasst.

Von Vorteil ist dabei, dass durch die Aufgespritzte Gleitschicht die Wartung des Gleitlagers insofern vereinfacht werden kann, da damit das Gleitlager durch relativ einfach realisierbaren Ausbau der Achse zugänglich wird. Dies kann sogar auf dem Turm der Windkraftanlage erfolgen, wodurch Zeit und damit Kosten eingespart werden können. Darüber hinaus hat die aufgespritzte Gleitschicht im Vergleich zu Gleitlagerbüchsen den Vorteil, dass Positionsverluste der Gleitlagerung durch Kriech- und Relaxationseffekte ausgeschlossen werden können. Das thermische Aufspritzen der Gleitschicht hat dabei den Vorteil, dass die Achse selbst während des Beschichtens thermisch nicht bzw. kaum belastet wird. Zudem flachen die Partikel beim Auftreffen auf die Achse ab, sodass sie in Richtung der Drehbewegung des Zahnrades ausgerichtet werden können, wodurch schierende Schichtbestandteile ihre Schmierwirkung durch einen längeren Laufweg in Umfangsrichtung besser ausbilden können.

Nach einer Ausführungsvariante des Windkraftanlagengetriebes kann vorgesehen sein, dass die Gleitschicht () aus einem Werkstoff besteht oder diesen umfasst, der ausgewählt ist aus einer Gruppe umfassend Aluminiumbasislegierungen, Bismutbasislegierungen, Silberbasislegierungen, Kupferbasislegierungen. Insbesondere diese verschleißresistenten und tribologisch besonders wirksamen Werkstoffe haben sich in kompakten Windkraftanlagengetrieben mit hoher Leistungsdichte und ohne den Einsatz von Lastausgleichstechnologien, wie zum Beispiel die so genannte "Flexible Pin Lösung", als besonders vorteilhaft herausgestellt. Zudem lassen sich diese Legierungen relativ einfach mit thermischen Spritzverfahren verarbeiten.

Es ist weiter möglich, dass auf der Gleitschicht eine polymerbasierte Einlaufschicht angeordnet ist, um damit eine bessere Anpassungsfähigkeit der Gleitlagerlauffläche an die Gegenlauffläche während des Einlaufens des Gleitschicht zu erreichen, wobei zusätzlich von Vorteil ist, dass diese Einlaufschicht ebenfalls die Tribologie des Gleitlagers an sich verbessert. Dabei ist von Vorteil, dass diese polymerbasierte Einlaufschicht mit einem Sprühverfahren aufgetragen werden kann, also mit einem Verfahren, dass eine gewisse Ähnlichkeit zu thermischen Spritzverfahren zeigt. Es kann damit die Herstellung der beschichteten Achse vereinfacht werden.

Nach einer anderen Ausführungsvariante des Windkraftanlagengetriebes kann vorgesehen sein, dass auf der Achse zwei in axialem Abstand zueinander angeordnete Gleitschichten mittels eines thermischen Spritzverfahrens aufgespritzt sind. Durch den Abstand der beiden Gleitschichten wird zwischen diesen eine Zwischenraum gebildet, der für die Ölzuführung über die Achse genutzt werden kann, wodurch eine bessere Beölung der Gleitschichten erreicht werden kann. Dabei ist von Vorteil, dass dieser Zwischenraum mittels dem thermischen Spritzverfahren einfach und ohne mechanische Bearbeitung hergestellt werden kann.

In der Gleitschicht können Hartpartikel und/oder Weichphasenpartikel eingelagert sein. Hierbei ist wieder von Vorteil, dass diese Partikel mit dem thermischen Spritzverfahren einfach mitverarbeitet werden können, sodass deren Einmischung in die Gleitschicht kein Problem darstellt, wie dies beispielsweise in Folge von Seigerungen in der Schmelzmetallurgie der Fall sein kann. Von Vorteil ist dabei, dass mit den Partikel u.a. auch die Körnigkeit des Gefüges der Gleitschicht einfach eingestellt werden kann. Es ist damit eine grobkörnige Gefügeausbildung einfach einstellbar, wodurch Diffusionsprozesse entlang der Korngrenzen und damit auch Versagensmechanismen die damit verbunden sind, wie z.B. das Korngrenzenkriechen oder die Abnahme des Gehalts eines Legierungselementes, vermindert werden, wodurch ein längerer Betrieb der Gleitlagerung möglich ist.

Die Hartpartikel sind bevorzugt ausgewählt aus einer Gruppe umfassend Metalloxide, Metallnitride, Metallcarbide, Metallboride, Metallsilizide. Es werden also bevorzugt keramische Hartpartikel eingesetzt, die einen relativ hohen Schmelzpunkt aufweisen. Es kann damit eine Vergröberung der Hartpartikel infolge von Diffusionserscheinungen besser vermieden werden, wodurch die Einstellbarkeit von bestimmten gewünschten tribologischen Eigenschaften der Gleitschicht mittels des thermischen Spritzverfahrens verbessert werden kann.

Die Weichphasenpartikel können ausgewählt sein aus einer Gruppe umfassend Graphit, hexagonales BN, Metallsulfide, wie MoS₂, WS₂ und ähnliche. Von Vorteil ist dabei, dass insbesondere BN reaktionsträge ist und beim Aufspritzen nicht oxidiert. Graphit verbrennt zwar teilweise während des Auftragens, die Oxide werden aber nicht in die Schicht eingebaut sondern verflüchtigen sich gasförmig. Sulfide können ebenfalls die Selbstschmiereigenschaften der Gleitschicht deutlich verbessern.

Nach einer Ausführungsvariante des Verfahrens kann vorgesehen sein, dass die Hartpartikel und/oder Weichpartikel während des Aufspritzens in der festen Form belassen werden. Diese Partikel schmelzen also während des Aufspritzens der Gleitschicht nicht, wodurch die Gefahr einer unbeabsichtigten Phasenänderung beim Spritzen verringert werden kann. Zudem kann damit eine Veränderung der Korngröße dieser Partikel besser vermieden werden. Dadurch ist wiederum die voranstehend genannte Gefügekorngröße der Legierung der Gleitschicht definierter einstellbar.

Das thermische Spritzenverfahren kann bevorzugt ausgewählt sein aus einer Gruppe bestehend aus Flammspritzen, Plasmaspritzen, Kaltgasspritzen, Laserspritzen, da diese Verfahren relativ einfach durchführbar sind.

Zum besseren Verständnis der Erfindung wird diese anhand der nachfolgenden Figuren näher erläutert.

Es zeigen jeweils in stark vereinfachter, schematischer Darstellung:
- Fig. 1: eine Windkraftanlage in Seitenansicht;
- Fig. 2: ein Windkraftanlagengetriebe in Form eines Planetengetriebes in Seitenansicht geschnitten;
- Fig. 3: einen Ausschnitt aus dem Windkraftanlagengetriebe in Seitenansicht geschnitten;
- Fig. 4: einen Ausschnitt aus einer Ausführungsvariante eines Windkraftanlagengetriebe in Seitenansicht geschnitten.

Einführend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind diese Lageangaben bei einer Lageänderung sinngemäß auf die neue Lage zu übertragen.

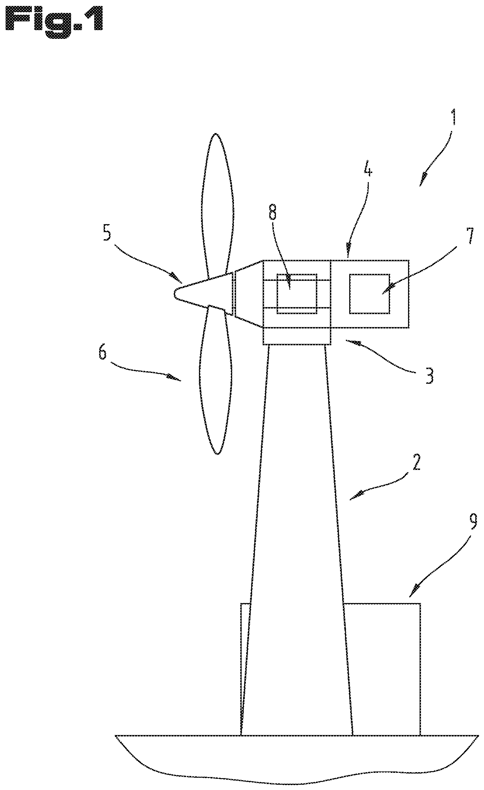

Fig. 1 zeigt eine Windkraftanlage 1. Diese Windkraftanlage 1 entspricht prinzipiell dem Stand der Technik, d.h. sie umfasst einen Turm 2 auf dem unter Zwischenanordnung einer Windrichtungsnachführeinrichtung 3 eine Gondel 4 angeordnet ist, an deren vorderen Ende ein Rotor 5 mit Rotorblättern 6 und an deren hinterem Ende ein Generator 7 angeordnet ist. Zwischen dem Rotor 5 und dem Generator 7, d.h. einem nicht weiter dargestellten Läufer des Generators, ist ein Windkraftanalgengetriebe 8 angeordnet, das einerseits mit dem Rotor 5 und andererseits dem Läufer des Generators 7 verbunden ist. Das Windkraftanlagengetriebe 8 dient der Erhöhung der Drehzahl des Läufers im Vergleich zum Rotor 5. Am unteren Teil des Turms 2 ist schließlich noch ein Netzanschluss 9 vorhanden.

Da diese Bestandteile prinzipiell aus dem Stand der Technik für Windkraftanlagen 1 bekannt sind, sei an dieser Stelle auf die einschlägige Literatur hierzu verwiesen. Es sei jedoch erwähnt, dass die Windkraftanlage 1 nicht zwingend auf den in Fig. 1 dargestellten Typ beschränkt ist.

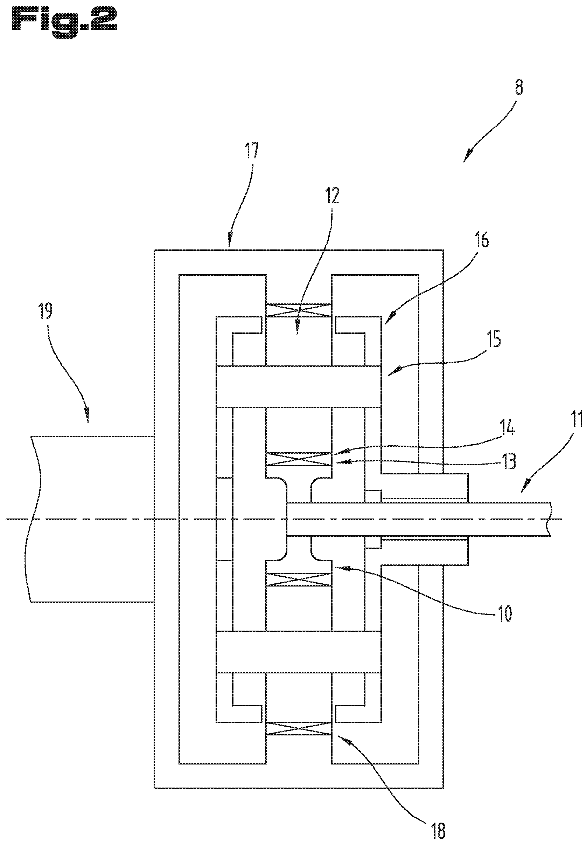

Fig. 2 zeigt das Windkraftanlagengetriebe 8 in Form eines einfachen Planetengetriebes in Seitenansicht geschnitten.

Das Windkraftanlagengetriebe 8 weist ein Sonnenrad 10 auf, das mit einer Welle 11, die zum Generatorrotor führt, drehfest verbunden ist. Das Sonnenrad 10 ist von mehreren Zahnrädern 12 in Form von Planetenrädern, beispielsweise zwei, vorzugsweise drei oder vier, umgeben. Das Sonnenrad 10 und die Zahnräder 12 weisen Stirnverzahnungen 13, 14 auf, die in kämmenden Eingriff miteinander stehen, wobei diese Stirnverzahnungen 13, 14 in Fig. 1 mit einem Kreuz angedeutet sind. Die die Zahnräder 12 sind auf einer Achse 15 (Planetenbolzen) gelagert. Diese Achsen 15 sind in Bohrungen eines Achsträgers 16 (Planetenträger) eingesetzt. Über den Zahnrädern 12 ist ein Hohlrad 17 angeordnet, das an einer inneren Oberfläche ebenfalls zumindest teilweise eine Verzahnung 18 aufweist, die in kämmenden Eingriff mit der Stirnverzahnung 14 der Zahnräder 12 steht. Das Hohlrad 17 ist drehfest mit einer Rotorwelle 19 des Rotors 5 der Windkraftanlage 1 (Fig. 1) verbunden. Die Stirnverzahnungen 13, 14 bzw. die Verzahnung 18 können als Geradverzahnung oder Schrägverzahnung ausgeführt sein.

Da derartige Planetengetriebe sind dem Prinzip nach ebenfalls bereits aus dem Stand der Technik bekannt sind, erübrigt sich eine weitere Erörterung an dieser Stelle. Es sei jedoch darauf hingewiesen, dass nicht nur einstufige Ausführungen von Planetengetrieben möglich sind, sondern auch mehrstufige, beispielsweise zwei- oder dreistufige.

Es sei darauf hingewiesen, dass im Folgenden hinsichtlich des Zahnrades 12 die Einzahl verwendet wird. Es versteht sich aber von selbst, dass die Erfindung auf sämtliche Zahnräder 12 eines derartigen Windkraftanlagengetriebes 8 anwendbar ist.

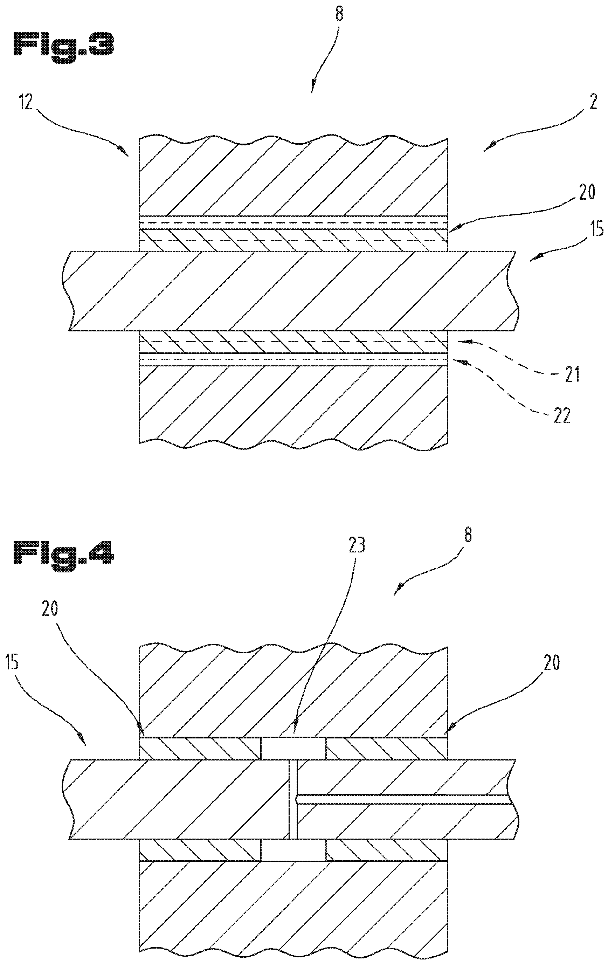

Fig. 3 zeigt einen Ausschnitt aus dem Windkraftanlagengetriebe 8 in Seitenansicht geschnitten im Bereich der Lagerung des Zahnrades 12 auf der Achse 15. Das Zahnrad 12 ist auf der Achse über eine Gleitlagerung gelagert. Dazu ist zwischen der Achse 15 und dem Zahnrad 12 eine Gleitschicht 20 angeordnet. Die Gleitschicht 20 ist direkt auf der Achse 15 angeordnet und mit dieser verbunden. Dazu wird der Werkstoff für die Gleitschicht 20 auf die Achse 15 mittels eines thermischen Spritzverfahrens aufgebracht.

Nach einer Ausführungsvariante dazu kann bei Bedarf vorgesehen sein, dass vor dem Auftragen der Gleitschicht 20 auf die Achse 15 zumindest eine weitere Schicht 21 aufgebracht wird, wie dies in Fig. 3 strichliert angedeutet ist. Vorzugsweise wird die weitere Schicht 21 ebenfalls mit einem thermischen Spritzverfahren auf die Achse 15 aufgebracht. Die weitere Schicht 21 kann beispielsweise eine Diffusionssperrschicht und/oder eine Haftvermittlerschicht und/oder eine Lagermetallschicht sein. Die Gleitschicht 20 wird bei dieser Ausführungsvariante direkt auf die weitere Schicht 21 aufgetragen.

Die Gleitschicht 20 ist eine metallische Schicht, insbesondere bestehend aus einer Metalllegierung bzw. diese umfassend. Der Werkstoff kann bevorzugt ausgewählt ist aus einer Gruppe umfassend Aluminiumbasislegierungen, Bismut-basislegierungen, Silberbasislegierungen, Kupferbasislegierungen. Es sind aber auch andere Legierungen verwendbar, beispielsweise Legierungen auf Indiumbasis, auf Bleibasis bzw. hochbleihältige CuPb-Basislegierungen. Bevorzugt werden jedoch bleifreie Legierungen eingesetzt. Bleifreie Legierungen sind dabei Legierungen, die Blei in einem maximalen Anteil enthalten, der dem Anteil an üblichen Verunreinigungen in derartigen Legierungen entspricht.

Die weitere Schicht 21 kann beispielsweise eine Aluminiumbasislegierungen, eine Zinnbasislegierungen, eine Kupferbasislegierungen, eine CuPb-Basislegierungen, eine AlSn-Basislegierungen, eine Legierungen auf AlZn-, AlSi-, AlSnSi-, CuAl-, CuSn-, CuZn-, CuSnZn-, CuZnSn-, CuBi- sowie AlBi-Basis, eine Reinmetallschicht aus Al, Ni, Co, Sn, etc., sein, mit der Maßgabe, dass sich die Zusammensetzung der weiteren Schicht 21 von jener der Gleitschicht 20 unterscheidet.

Es kann nach einer anderen Ausführungsvariante vorgesehen sein, dass auf der Gleitschicht 20 eine Einlaufschicht 22 angeordnet ist, die in diesem Fall die radial äußere Schicht bildet und in gleitendem Kontakt mit dem Zahnrad 12 gebracht wird. Die Einlaufschicht 22 kann beispielsweise eine Reinmetallschicht sein, z.B. Zinn. Bevorzugt ist die Einlaufschicht 22 allerdings eine polymerbasierte Einlaufschicht 22. Als Polymer wird insbesondere ein Polyimid oder eine Polyamidimid eingesetzt. Weiter kann die Einlaufschicht auch einen Anteil an Festschmierstoffen enthalten, beispielsweise MoS₂ und/oder Grafit. Der Anteil an dem Polymer an der Einlaufschicht 22 kann zwischen 40 Gew.-% und 80 Gew.-% betragen. Den Rest auf 100 Gew.-% bilden die Festschmierstoffe.

Es ist weiter möglich, dass in der Gleitschicht 20 Hartpartikel und/oder Weichphasenpartikel eingelagert sind. Die Hartpartikel können ausgewählt sein aus einer Gruppe umfassend Metalloxide, wie beispielsweise MgO, TiO₂, ZrO₂, Al₂O₃, Metallnitride, Metallcarbide, wie beispielsweise SiC, WC, B₄C Metallboride, Metallsilizide. Die Weichphasenpartikel können ausgewählt sein aus einer Gruppe umfassend Graphit, hexagonales BN, Metallsulfide.

Es sei erwähnt, dass die Hartpartikel eine größere Härte aufweisen, als die Matrix der Gleitschicht 20, in der sie eingebettet sind. Die Weichphasenpartikel weisen hingegen eine kleinere Härte auf, als die Matrix der Gleitschicht 20, in der sie eingebettet sind.

Der Anteil der Hartpartikel und/oder Weichphasenpartikel an der Gleitschicht 20 kann ausgewählt sein aus einem Bereich von 3 Gew.% bis 25 Gew.%, insbesondere von 5 Gew.% bis 20 Gew.%.

Gemäß einer anderen Ausführungsvariante kann die mittlere Partikelgröße der Weichphasenpartikel und/oder Hartphasenpartikel zwischen 1 µm bis 100 µm, vorzugsweise 5 µm bis 20 µm, betragen.

In Fig. 4 ist ein Ausschnitt einer weiteren Ausführungsvariante des Windkraftanlagengetriebes 8 im Längsschnitt dargestellt. Zum Unterschied zur voranstehend ausgeführten Ausführungsvariante des Windkraftanlagengetriebes 8 sind bei dieser Ausführungsvariante auf der Achse 15 zwei in axialem Abstand zueinander angeordnete Gleitschichten 20 mittels eines thermischen Spritzverfahrens aufgespritzt. Durch die axiale Beabstandung der beiden Gleitschichten 20 ist zwischen diesen ein Zwischenraum 23 ausgebildet. Dieser kann zur Zuführung eines Schmiermittels verwendet werden. Die Schmiermittelzuführung kann dabei (ausschließlich) über die Achse 15 erfolgen wie dies strichliert angedeutet ist.

Zur besseren Verteilung des Schmiermittels über zumindest annähernd die ge-samten Laufflächen kann der Zwischenraum 7 über zumindest eine Ver-bindungsleitung mit der Umgebungsatmosphäre verbunden sein. Bevorzugt verläuft die Verbindungsleitung in der Achse 15.

Es sei erwähnt, dass anstelle von zwei Gleitschichten 20 auch mehr als zwei Gleitschichten 20 auf die Achse 15 aufgespritzt sein können.

Wie bereits erwähnt, wird die Gleitschicht 20 mit einem thermischen Spritzverfahren auf die Achse 15 aufgespritzt. Bevorzugt wird dazu ein Spritzverfahren eingesetzt, das ausgewählt aus einer Gruppe bestehend aus Flammspritzen, beispielsweise Drahtflammspritzen oder Hochgeschwindigkeits-Flammspritzen, z.B. HVOF (High-Velocity-Oxygen-Fuel) oder HVAF (High-Velocity-Air-Fuel), Plasmaspritzen, Kaltgasspritzen, Laserspritzen.

Nach einer Ausführungsvariante dazu kann vorgesehen sein, dass ein Spritzwerk-stoff verwendet wird, in dem die Hartpartikel und/oder Weichphasenpartikel enthalten sind, wobei die Hartpartikel und/oder die Weichphasenpartikel während des Aufspritzens in der festen Form belassen werden. Es wird dazu eine metallische Legierung gewählt, die einen geringeren Schmelzpunkt aufweist, als die Hartpartikel und/oder die Weichphasenpartikel.

Vor dem Aufspritzen der Gleitschicht 20 oder der weiteren Schicht 21 auf die Achse 15, die insbesondere aus einem Stahl besteht, wird die Achse vorzugsweise vorbehandelt. Diese Vorbehandlung umfasst vorzugsweise eine Aufrauhung der Oberfläche der Achse 15 zumindest im dem Bereich, in dem die Gleitschicht 20 oder die weitere Schicht 21 aufgebracht wird. Insbesondere wird die Achse 15 in diesem Bereich gestrahlt.

Danach wird die Achse 15 vorzugsweise gereinigt.

Der Spritzwerkstoff kann in Draht- oder Pulverform eingesetzt werden.

Das Aufspritzen der Gleitschicht 20 und/oder der weiteren Schicht 21 kann auch unter Vakuum oder Schutzgasatmosphäre erfolgen.

Nach dem Aufspritzen kann die Gleitschicht 20 und/oder die weitere Schicht 21 nachbehandelt werden.

Die Ausführungsbeispiele zeigen mögliche Ausführungsvarianten, wobei an dieser Stelle bemerkt sei, dass auch Kombinationen der einzelnen Ausführungsvarianten untereinander im Rahmen der beigefügten Ansprüche möglich sind.

Der Ordnung halber sei abschließend darauf hingewiesen, dass zum besseren Verständnis des Windkraftanlagengetriebes 8 bzw. der Windkraftanlage 1 diese nicht zwingenderweise maßstäblich dargestellt sind.

### Bezugszeichenaufstellung

- 1: Windkraftanlage
- 2: Turm
- 3: Windrichtungsnachführeinrichtung
- 4: Gondel
- 5: Rotor
- 6: Rotorblättern
- 7: Generator
- 8: Windkraftanlagengetriebe
- 9: Netzanschluss
- 10: Sonnenrad
- 11: Welle
- 12: Zahnrad
- 13: Stirnverzahnung
- 14: Stirnverzahnung
- 15: Achse
- 16: Planetenträger
- 17: Hohlrad
- 18: Verzahnung
- 19: Rotorwelle
- 20: Gleitschicht
- 21: Schicht
- 22: Einlaufschicht
- 23: Zwischenraum

## Patentansprüche

1. Windkraftanlagengetriebe (8), insbesondere Planetengetriebe, mit zumindest einem Zahnrad (12), das auf einer Achse (15) gelagert ist, wozu zwischen dem Zahnrad (12) und der Achse (15) eine Gleitschicht (20) angeordnet ist, **dadurch gekennzeichnet, dass** die Gleitschicht (20) mittels eines thermischen Spritzverfahrens direkt auf die Achse (15) oder unter Zwischenanordnung von zumindest einer weiteren Schicht (21) auf die weitere Schicht (21) aufgespritzt ist.

2. Windkraftanlagengetriebe (8) nach Anspruch 1, **dadurch gekennzeichnet, dass** die Gleitschicht (20) aus einem Werkstoff besteht oder diesen umfasst, der ausgewählt ist aus einer Gruppe umfassend Aluminiumbasislegierungen, Bismutbasislegierungen, Silberbasislegierungen, Kupferbasislegierungen.

3. Windkraftanlagengetriebe (8) nach Anspruch 1 oder 2, **dadurch gekennzeichnet, dass** auf der Gleitschicht (20) eine polymerbasierte Einlaufschicht angeordnet ist.

4. Windkraftanlagengetriebe (8) nach einem der Ansprüche 1 bis 3, **dadurch gekennzeichnet, dass** auf der Achse (15) zwei in axialem Abstand zueinander angeordnete Gleitschichten (20) mittels eines thermischen Spritzverfahrens aufgespritzt sind.

5. Windkraftanlagengetriebe (8) nach einem der Ansprüche 1 bis 4, **dadurch gekennzeichnet, dass** in der Gleitschicht Hartpartikel und/oder Weichphasenpartikel eingelagert sind.

6. Windkraftanlagengetriebe (8) nach Anspruch 5, **dadurch gekennzeichnet, dass** die Hartpartikel ausgewählt sind aus einer Gruppe umfassend Metalloxide, Metallnitride, Metallcarbide, Metallboride, Metallsilizide und/oder dass die Weichphasenpartikel ausgewählt sind aus einer Gruppe umfassend Graphit, hexagonales BN, Metallsulfide.

7. Windkraftanlage (1) mit einem Rotor (5) und einem Generator (7), wobei zwischen dem Rotor (5) und dem Generator (7) ein Windkraftanlagengetriebe (8), insbesondere ein Planetengetriebe, angeordnet ist, das in Wirkverbindung mit dem Rotor (5) und dem Generator (7) steht, **dadurch gekennzeichnet, dass** das Windkraftanlagengetriebe (8) entsprechend einem der vorhergehenden Ansprüche ausgebildet ist.

8. Verfahren zur Herstellung einer Achse (15) für ein Windkraftanlagengetriebe (8) nach einem der Ansprüche 1 bis 7, insbesondere ein Planetengetriebe, umfassend die Schritte:
- Bereitstellen der Achse (15),
- Aufspritzen einer Gleitschicht (20) aus einem Spritzwerkstoff mit einem thermischen Spritzverfahren direkt auf die Achse (15) oder nach dem Auftrag zumindest einer metallischen Zwischenschicht auf die Zwischenschicht.

9. Verfahren nach Anspruch 8, **dadurch gekennzeichnet, dass** ein Spritzwerkstoff verwendet wird, in dem die Hartpartikel und/oder Weichphasenpartikel enthalten sind, wobei die Hartpartikel und/oder die Weichphasenpartikel während des Aufspritzens in der festen Form belassen werden.

10. Verfahren nach Anspruch 8 oder 9, **dadurch gekennzeichnet, dass** das Aufspritzen der Gleitschicht (20) und /oder der weiteren metallischen Schicht (21) mit einem thermischen Spritzverfahren durchgeführt wird, das ausgewählt ist aus einer Gruppe bestehend aus Flammspritzen, Plasmaspritzen, Kaltgasspritzen, Laserspritzen.

## Claims

1. A wind turbine gearbox (8), in particular a planetary gearbox, having at least one gear (12) mounted on an axle (15), for which purpose a sliding layer (20) is arranged between the gear (12) and the axle (15), **characterized in that** the sliding layer (20) is sprayed directly onto the axle (15) or, with intermediate arrangement of at least one further layer (21), onto the further layer (21) by means of a thermal spaying method.

2. The wind turbine gearbox (8) according to claim 1, **characterized in that** the sliding layer (20) consists of or comprises a material selected from a group comprising aluminum base alloys, bismuth base alloys, silver base alloys, copper base alloys.

3. The wind turbine gearbox (8) according to claim 1 or 2, **characterized in that** a polymer-based running-in layer is arranged on the sliding layer (20).

4. The wind turbine gearbox (8) according to one of claims 1 to 3, **characterized in that** two sliding layers (20) arranged at an axial distance from one another are sprayed onto the axle (15) by means of a thermal spaying method.

5. The wind turbine gearbox (8) according to one of claims 1 to 4, **characterized in that** hard particles and/or soft phase particles are embedded in the sliding layer.

6. The wind turbine gearbox (8) according to claim 5, **characterized in that** the hard particles are selected from a group comprising metal oxides, metal nitrides, metal carbides, metal borides, metal silicides and/or that the soft phase particles are selected from a group comprising graphite, hexagonal BN, metal sulphides.

7. A wind turbine (1) having a rotor (5) and a generator (7), wherein a wind turbine gearbox (8), in particular a planetary gearbox, which is operatively connected to the rotor (5) and the generator (7) is arranged between the rotor (5) and the generator (7), **characterized in that** the wind turbine gearbox (8) is designed according to one of the preceding claims.

8. A method for producing an axle (15) for a wind turbine gearbox (8) according to one of claims 1 to 7, in particular a planetary gearbox, comprising the steps:
- providing the axle (15),
- spraying a sliding layer (20) of a spraying material directly onto the axle (15) or, after application of at least one metallic intermediate layer, onto the intermediate layer by means of a thermal spaying method.

9. The method according to claim 8, **characterized in that** a spraying material in which hard particles and/or soft phase particles are contained is used, wherein the hard particles and the soft phase particles are kept in the solid form during spraying on.

10. The method according to claim 8 or 9, **characterized in that** spraying on the sliding layer (20) and/or the further metal layer (21) is carried out by means of a thermal spaying method selected from a group consisting of flame spraying, plasma spraying, cold spraying, laser spraying.

## Revendications

1. Multiplicateur d'éolienne (8), plus particulièrement engrenage planétaire, avec au moins une roue dentée (12) qui est logée sur un axe (15), une couche de glissement (20) étant disposée pour cela entre la roue dentée (12) et l'axe (15), **caractérisé en ce que** la couche de glissement (20) est projetée, au moyen d'un procédé de projection thermique directement sur l'axe (15) ou en intercalant au moins une autre couche (21) sur l'autre couche (21).

2. Multiplicateur d'éolienne (8) selon la revendication 1, **caractérisé en ce que** la couche de glissement (20) est constituée d'un matériau ou comprend ce matériau, qui est sélectionné dans un groupe comprenant des alliages à base d'aluminium, des alliages à base de bismuth, des alliages à base d'argent, des alliages à base de cuivre.

3. Multiplicateur d'éolienne (8) selon la revendication 1 ou 2, **caractérisé en ce que**, sur la couche de glissement (20) est disposée une couche d'entrée à base de polymères.

4. Multiplicateur d'éolienne (8) selon l'une des revendications 1 à 3, **caractérisé en ce que**, sur l'axe (15) sont projetées deux couches de glissement (20) disposées à une distance axiale entre elles, au moyen d'un procédé de projection thermique.

5. Multiplicateur d'éolienne (8) selon l'une des revendications 1 à 4, **caractérisé en ce que**, dans la couche de glissement, sont intégrées dans particules dures et/ou des particules de phase molle.

6. Multiplicateur d'éolienne (8) selon la revendication 5, **caractérisé en ce que** les particules dures sont sélectionnées dans un groupe comprenant des oxydes métalliques, des nitrures métalliques, des carbures métalliques, des borures métalliques, des siliciures métalliques et/ou **en ce que** les particules de phase molle sont sélectionnées dans un groupe comprenant du graphite, un nitrure de bore hexagonal, des sulfures métalliques.

7. Éolienne (1) avec un rotor (5) et un générateur (7), dans laquelle, entre le rotor (5) et le générateur (7) est disposé un multiplicateur d'éolienne (8), plus particulièrement un engrenage planétaire, qui est en liaison fonctionnelle avec le rotor (5) et le générateur (7), **caractérisée en ce que** le multiplicateur d'éolienne (8) est conçu selon l'une des revendications précédentes.

8. Procédé de fabrication d'un axe (15) pour un multiplicateur d'éolienne (8) selon l'une des revendications 1 à 7, plus particulièrement un engrenage planétaire, comprenant les étapes suivantes :
- mise à disposition de l'axe (15),
- projection d'une couche de glissement (20) constituée d'un matériau de projection avec un procédé de projection thermique directement sur l'axe (15) ou après l'application d'au moins une couche intermédiaire métallique sur la couche intermédiaire.

9. Procédé selon la revendication 8, **caractérisé en ce qu'**un matériau de projection est utilisé, dans lequel les particules dures et/ou les particules de phase molle sont contenues, dans lequel les particules dures et/ou les particules de phase molle sont laissées dans la forme solide pendant la projection.

10. Procédé selon la revendication 8 ou 9, **caractérisé en ce que** la projection de la couche de glissement (20) et/ou de l'autre couche métallique (21) est effectuée avec un procédé de projection thermique qui est sélectionné dans un groupe constitué d'une projection à la flamme, d'une projection de plasma, d'une projection de gaz à froid, d'une projection par laser.
